Europäisches Patentamt

European Patent Office

Office européen des brevets

(11) Publication number: 0 498 449 A2

# EUROPEAN PATENT APPLICATION

(21) Application number: 92102074.9

(22) Date of filing: 07.02.92

(51) Int. Cl.⁵: G01R 31/28

(30) Priority: 07.02.91 JP 4473/91 U

(43) Date of publication of application:
12.08.92 Bulletin 92/33

(84) Designated Contracting States:
DE FR GB

(71) Applicant: NEC CORPORATION
7-1, Shiba 5-chome Minato-ku
Tokyo 108-01(JP)

(72) Inventor: Mano, Hirofumi
c/o NEC Corporation, 7-1, Shiba 5-chome
Minato-ku, Tokyo(JP)

(74) Representative: Betten & Resch
Reichenbachstrasse 19
W-8000 München 5(DE)

(54) Semiconductor integrated circuit device having dynamic burn-in circuit.

(57) A semiconductor integrated circuit device equipped with a static burn-in device has a dynamic burn-in circuit for a user's circuit. The dynamic burn-in circuit includes at least a ring oscillator (1), a frequency divider (3), a selector (4), an input terminal (5) for controlling the oscillation of the ring oscillator, and an input terminal (6) for receiving clock pulses for an ordinary operation. The user's circuit (8) receives through the selector a burn-in clock signal generated by the self-oscillation of the ring oscillator while a burn-in testing is conducted instead of the clock pulse signal for the ordinary operation being received while the ordinary operation is performed. This dynamic burn-in circuit is realized without the need of using a costly dedicated dynamic burn-in device.

FIG. 1

## BACKGROUND OF THE INVENTION

The present invention relates to a semiconductor integrated circuit device, and more particularly to a large scale integrated circuit device (hereinafter referred to as an "LSI") having therein a means to realize a dynamic burn-in testing.

Conventionally there exists a dedicated dynamic burn-in device. However, as to such a conventional dedicated dynamic burn-in device, the price thereof is several times higher as compared with the static burn-in device. Moreover, among the users of LSIs, those who require the dynamic burn-in are particularly limited to users dealing only with such as vehicles and aerial and space navigation. The purchasing and installing of the dynamic burn-in device only by such users have involved difficulties from the stand point of cost.

## SUMMARY OF THE INVENTION

It is a primary object of the present invention to overcome the above problems and to provide an improved semiconductor integrated circuit device which has a static burn-in function but also has a dynamic burn-in function.

According to one aspect of the present invention, a semiconductor integrated circuit device equipped with a static burn-in device is characterized in that it has a dynamic burn-in circuit for a user's circuit.

The dynamic burn-in circuit is provided internally of the device so that it is possible to realize the dynamic burn-in testing without the need of using a dedicated dynamic burn-in device,

## BRIEF DESCRIPTION OF THE DRAWINGS

The above and other objects, features and advantages of the present invention will be apparent from the following description of preferred embodiments of the invention explained with reference to the accompanying drawings, in which:
Fig. 1 is a block diagram showing a semiconductor integrated circuit device of a first embodiment according to the present invention;
Fig. 2 is a block diagram showing an arrangement of another embodiment according to the present invention; and
Fig. 3 is a circuit diagram showing a static burn-in circuit board.

## DESCRIPTION OF THE PREFERRED EMBODIMENTS

For a better understanding of the present invention, together with other and further objects, advantages and capabilities thereof, reference is made to the following disclosure and appended claims in connection with the above described drawings.

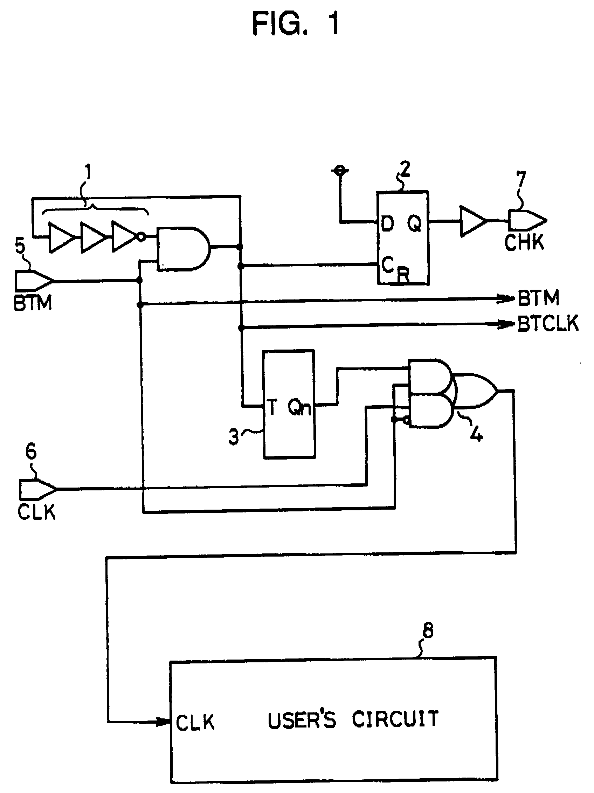

Referring now to the invention with greater particularity, there is shown in Fig. 1 in a block diagram a dynamic burn-in circuit of a first embodiment according to the present invention.

As shown in Fig. 1, the device of the first embodiment includes a ring oscillator 1, a flip-flop circuit (F/F) 2 for checking the oscillation of the ring oscillator 1, a frequency divider 3, a selector 4, an input terminal 5 for receiving a signal for controlling the oscillation of the rind oscillator, an input terminal 6 for receiving a clock signal for an ordinary operation, an output terminal 7 for checking the oscillation of the ring oscillator, and a circuit 8 to be prepared by a user.

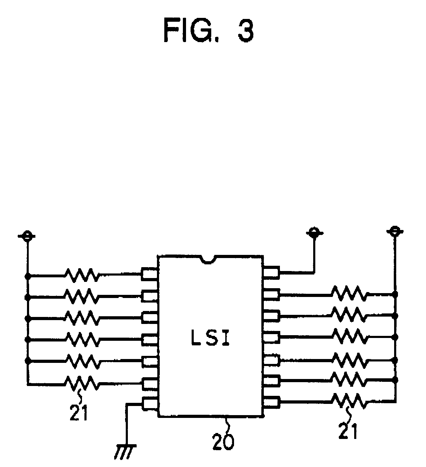

Fig. 3 is a diagram showing a circuit board for a static burn-in testing. According to this embodiment, when an LSI 20 is to be burned-in, the LSI 20 is mounted on the circuit board as shown in Fig. 3. In carrying out the burning-in testing, all the input-output terminals excepting the power source terminal are connected to the power supply source through respective resistors 21. Thus, the input terminal (BTM) 5 for controlling the oscillation of the ring oscillator is pulled-up to a high level (HIGH). Then, the ring oscillator 1 starts oscillating. The oscillation pulse signal is divided through the frequency divider 3 and the resultant pulse signal is supplied as an clock pulse signal to the user's circuit 8 through a selector 4 instead of the clock signal supplied from the input terminal (CLK) 6 in the ordinary or normal operation.

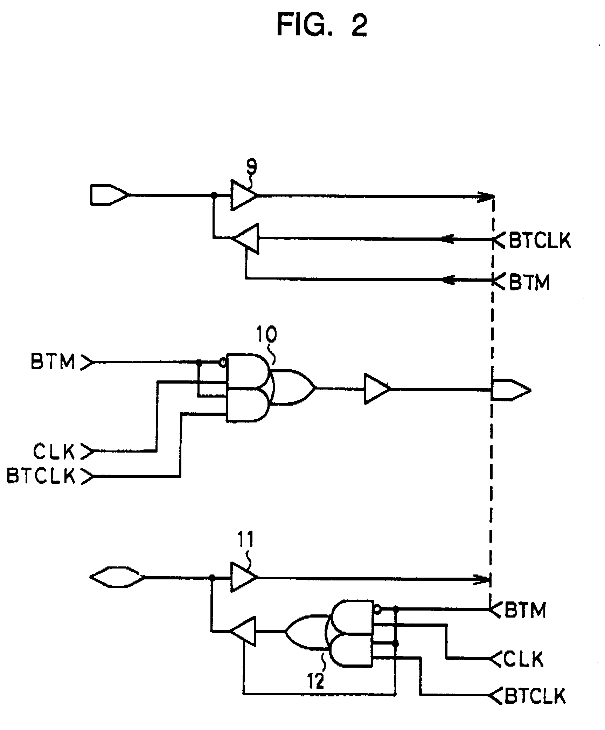

Fig. 2 is a diagram showing a dynamic burn-in circuit of another embodiment according to the present invention. As shown in Fig. 2, the device is equipped with an input buffer 9, an output buffer 10, an input-output buffer 11 and a selector 12.

The input buffer 9 is replaced for the input-output buffer 11 and switches the I/O control in such a way that the oscillation pulse of the ring oscillator is inputted to the input buffer 9 when the burn-in testing is performed. The output buffer 10 switches the selector of the output buffer 10 so that the oscillation pulse of the ring oscillator enters there when the burn-in testing is performed. The input-output buffer 11 switches the I/O control to an output mode and also switches the selector 12 so that the oscillation pulse of the ring oscillator passes through the input-output buffer 11 when the burn-in testing is performed. The dynamic circuit is thus realized in the burn-in process.

According to this embodiment, the ring oscillator causes the self-oscillation to occur internally of the LSI thereby enabling to realize the dynamic burn-in testing.

As explained above, according to the present invention, since the dynamic burn-in circuit is provided internally of the device, it is possible to realize the dynamic burn-in testing without the need of using a costly dedicated dynamic burn-in device.

While the invention has been described in its preferred embodiments, it is to be understood that the words which have been used are words of description rather than limitation and that changes within the purview of the appended claims may be made without departing from the true scope and spirit of the invention in its broader aspects.

**Claims**

1. A semiconductor integrated circuit device equipped with a static burn-in device, said integrated circuit device is characterized by comprising a dynamic burn-in circuit for a user's circuit (8).

2. A semiconductor integrated circuit device according to claim 1, wherein the dynamic burn-in circuit has a ring oscillator (1) which performs a self-oscillation internally of the device while a burn-in testing is being conducted.

3. A semiconductor integrated circuit device according to claim 1, wherein said dynamic burn-in circuit comprises:

   a ring oscillator (1) for generating oscillation pulses while the burn-in testing is conducted;

   an input terminal (5) for controlling an oscillation of said ring oscillator;

   an input terminal (6) for receiving clock pulses for an ordinary operation;

   a frequency divider (3) for dividing said oscillation pulses generated by said ring oscillator into burn-in clock pulses: and

   a selector (4) for supplying to said user's circuit (8) the clock pulses supplied from the input terminal for receiving the clock pulses for the ordinary operation while the ordinary operation is effected and the burn-in clock pulses from said frequency divider (3) while the burn-in testing is effected.

4. A semiconductor integrated circuit device according to claim 3, wherein said dynamic burn-in circuit further comprises a flip-flop (2) and an output terminal (7) for checking the oscillation of said ring oscillator (1).

# FIG. 1

# FIG. 2

# FIG. 3